# EUROPEAN PATENT APPLICATION

(11) **EP 2 073 316 A1**
(43) Date of publication of application: **24.06.2009**
(21) Application number: 07807629.6
(22) Date of filing: 20.09.2007
(51) Int. Cl.: H01R 11/01, C09J 9/02, C09J 11/04, C09J 201/00, H01B 1/20, H01B 5/00, H01B 13/00, H01L 21/60, H05K 1/14, H05K 3/32, H05K 3/36

(54) **ANISOTROPIC CONDUCTIVE ADHESIVE COMPOSITION, ANISOTROPIC CONDUCTIVE FILM, CIRCUIT MEMBER CONNECTING STRUCTURE AND METHOD FOR MANUFACTURING COATED PARTICLES**

(30) Priority: 26.09.2006 JP 2006260927
(71) Applicant: Hitachi Chemical Company, Ltd., Tokyo 163-0449 (JP)
(72) Inventor: TAKANE,Nobuaki, Tsukuba-shi Ibaraki 300-4247 (JP)
(74) Representative: Jönsson, Hans-Peter
(86) International application number: PCT/JP2007/068265
(87) International publication number: WO 2008/038565

(57) **Abstract**

The anisotropically conductive adhesive composition according to the present invention is an anisotropically conductive adhesive composition to connect a first circuit member where a first circuit electrode is formed on the principal surface of a first substrate and a second circuit member where a second circuit electrode is formed on the principal surface of a second substrate with the first circuit electrode and the second circuit electrode placed opposite, wherein the anisotropically conductive adhesive composition comprises an adhesive and a coated particle where at least part of the surface of a conductive particle is coated with an insulating material containing a polymer electrolyte and an inorganic oxide fine particle.

## Description

### Technical Field

The present invention relates to an anisotropically conductive adhesive composition, an anisotropically conductive film, a circuit member-connecting structure, and a process for producing a coated particle and more specifically to an anisotropically conductive adhesive composition used to connect circuit substrates together or an electronic part such as an IC chip and a wiring board and an anisotropically conductive film and a circuit member-connecting structure that both use the composition, and a process for producing a coated particle.

### Background Art

An anisotropically conductive adhesive composition prepared by dispersing a conductive particle into an adhesive composition is used to electrically connect circuit substrates together or an electronic part such as an IC chip and a circuit substrate. More specifically, connecting together the electrodes of circuit members placed opposite as above by putting this anisotropically conductive adhesive composition between the electrodes and heating and pressurizing the composition can provide electric conductivity in the direction of pressurization to electrically connect the electrodes placed opposite and fix the circuit members together (e.g., see Patent Documents 1 and 2).

In addition, liquid crystal display (LCD) driver ICs are mounted on glass panels for LCDs by chip-on-glass (COG) packaging, chip-on-flex (COF) packaging, or the like. In COG packaging, LCD driver ICs are bonded directly to a glass panel with an anisotropically conductive adhesive composition containing a conductive particle. In COF packaging, LCD driver ICs are bonded to a flexible tape having metal wiring, which is then bonded to a glass panel with an anisotropically conductive adhesive composition containing a conductive particle.

However, with recent higher-resolution liquid crystal display, gold bumps as the circuit electrodes for IC chips have been made to have a finer pitch and a smaller area while other electric parts have also been more miniaturized. A problem caused by this trend is that a conductive particle contained in an anisotropically conductive adhesive composition easily causes a short circuit because the particle passes between neighboring circuit electrodes.

As methods of solving this problem, a method which prevents bond quality from deteriorating in COG packaging or COF packaging by forming an insulating adhesive layer on at least one side of a circuit-connecting member (e.g., see Patent Document 3) and a method which coats the entire surface of a conductive particle with an insulating film (e.g., see Patent Document 4) have been developed. In addition, a method which uses a coated particle where part of the surface of a conductive particle is coated with an insulating fine particle has also been suggested (e.g., see Patent Documents 5 and 6). In addition, as such an insulating coating method, a method which alternately laminates a polyanion thin film and a polycation thin film which are both polymer electrolyte thin films has been suggested (e.g., see Patent Document 7).

Patent Document 1: Japanese Patent No. 3581618
Patent Document 2: Japanese Patent No. 3679618
Patent Document 3: Japanese Patent Laid-Open No. HEI 8-279371
Patent Document 4: Japanese Patent No. 2794009
Patent Document 5: Japanese Patent Laid-Open No. 2005-197089
Patent Document 6: International Publication WO2003/025955
Patent Document 7: Japanese Patent Laid-Open No. 2003-317827

### Disclosure of the Invention

However, in the method according to Patent Document 3 which forms an insulating adhesive layer on one side of a circuit-connecting member, the insulation between neighboring circuit electrodes leaves room for improvement, for example, if the bump area is 3000 µm² or less and the number of conductive particles is to be increased to achieve stable connection resistance. In addition, a problem of the method according to Patent Document 4 which coats the entire surface of a conductive particle with an insulating film is that no stable electric resistance can be obtained because the connection resistance between circuit electrodes placed opposite increases. Furthermore, a problem of the method according to Patent Document 5 which uses a coated particle where part of the surface of a conductive particle is coated with an insulating fine particle is that repeated reliability tests increase the resistance value. In addition, problems of the method of forming a coated particle according to Patent Document 6 are that a process is required to introduce a functional group(s) on a conductive particle and an insulating particle and that because of weak interaction between both particles and the functional group(s), the insulating particle is difficult to aggregate on the conductive particle, resulting in poor yield and variation in insulation. In addition, a problem of the method of forming a coated particle according to Patent Document 7 is that no stable electric resistance can be obtained because of increased connection resistance between circuit electrodes placed opposite although the surface of a conductive particle can be uniformly coated without defects.

The present invention has been made in view of the problems of the conventional art and an object thereof is to provide an anisotropically conductive adhesive composition which can sufficiently prevent the aggregation of a dispersed conductive particle from causing a short circuit between neighboring circuit electrodes and can thus provide excellent long-term connection reliability even for fine-pitch connection, an anisotropically conductive film and a circuit member-connecting structure that both use the composition, and a process for producing a coated particle.

To achieve the object, the present invention provides an anisotropically conductive adhesive composition to connect a first circuit member where a first circuit electrode is formed on the principal surface of a first substrate and a second circuit member where a second circuit electrode is formed on the principal surface of a second substrate with the first circuit electrode and the second circuit electrode placed opposite, wherein the anisotropically conductive adhesive composition comprises an adhesive and a coated particle where at least part of the surface of a conductive particle is coated with an insulating material containing a polymer electrolyte and an inorganic oxide fine particle.

Since the anisotropically conductive adhesive composition according to the present invention uses the coated particle above as a conductive material instead of a typical conductive particle, even if the coated particle aggregates for fine-pitch connection (e.g., for a narrow space between neighboring electrodes that is 15 µm or less), a short circuit between electrodes can be sufficiently prevented because a film comprising an insulating material containing a polymer electrolyte and an inorganic oxide fine particle maintains the insulation between the conductive particles. In addition, the pressure used when circuit members are connected together provides electric conductivity in the direction of pressurization between electrodes placed opposite, which ensures electric connection. If an inorganic oxide fine particle is used as an insulating material, deformation due to pressurization and heating and its return are small in the connection step, which prevents an increase in the resistance of the connection and subsequent increases in the resistance and provides excellent long-term connection reliability. In addition, the insulating material containing the polymer electrolyte eliminates the need for a process for introducing a functional group on the surfaces of the conductive particle and the insulating particle, which provides high-yield production and makes it difficult to cause variation in insulation.

In addition, in the anisotropically conductive adhesive composition according to the present invention, the coated particle is preferably a particle prepared by electrostatically adsorbing the polymer electrolyte and an inorganic oxide fine particle alternately on at least part of the surface of the conductive particle. The adsorption of the polymer electrolyte on the surface of the conductive particle allows electrostatic attraction to act between the polymer electrolyte and the inorganic oxide fine particle, which allows the inorganic oxide fine particle to be selectively adsorbed on the surface of the conductive particle. This seems to be because the inorganic oxide fine particle has a polar group such as a hydroxy group on the surface thereof.

In addition, in the anisotropically conductive adhesive composition according to the present invention, the inorganic oxide fine particle is preferably a particle comprising an oxide containing at least one element selected from the group consisting of silicon, aluminum, zirconium, titanium, niobium, zinc, tin, cerium, and magnesium. This allows such a particle to act as a chemically and thermally stable insulating particle.

In addition, in the anisotropically conductive adhesive composition according to the present invention, the mean particle size of the inorganic oxide fine particle is preferably in the range of 20 to 500 nm (both inclusive). The mean particle size of the inorganic oxide fine particle in the above range can ensure sufficient insulation between neighboring electrodes and sufficient conduction in the direction of pressurization during connection.

Furthermore, in the anisotropically conductive adhesive composition according to the present invention, the polymer electrolyte preferably contains no alkali metal ion, alkaline earth metal ion, or halide ion. This can prevent the occurrence of electromigration and corrosion sufficiently.

The present invention also provides an anisotropically conductive film into which the anisotropically conductive adhesive composition is formed.

Since this anisotropically conductive film uses the anisotropically conductive adhesive composition according to the present invention, aggregation of a dispersed conductive particles can sufficiently prevent the occurrence of a short circuit between neighboring circuit electrodes even for fine-pitch connection, providing excellent long-term connection reliability. In addition, this anisotropically conductive film is easy to handle because of its film form.

The present invention also provides a circuit member-connecting structure wherein a first circuit member where a first circuit electrode is formed on the principal surface of a first substrate and a second circuit member where a second circuit electrode is formed on the principal surface of a second substrate are connected by a circuit-connecting member comprising a cured product of the anisotropically conductive adhesive composition according to the present invention put between the first circuit member and the second circuit member so that the first circuit electrode and the second circuit electrode are placed opposite and electrically connected.

Since the circuit-connecting member comprises a cured product of the anisotropically conductive adhesive composition according to the present invention, this circuit member-connecting structure can sufficiently prevent the occurrence of a short circuit between neighboring circuit electrodes by aggregation of a dispersed conductive particle even for fine-pitch connection, providing excellent long-term connection reliability.

Here, in the first circuit member, it is preferable that the first substrate be a glass substrate and that the first circuit electrode be a metal electrode circuit while in the second circuit member the second substrate is preferably an organic insulating substrate. This allows for easy connection between the very flexible organic insulating substrate and the glass substrate.

In addition, in the first circuit member, the first substrate is preferably a semiconductor chip while in the second circuit member it is preferable that the second substrate be a glass substrate and that the second circuit electrode be a metal electrode circuit. This allows for easy direct mounting of the semiconductor chip on the glass substrate.

The present invention further provides a process for producing a coated particle where at least part of the surface of a conductive particle is coated with an insulating material, wherein the process comprises an adsorption step which alternately repeats a first step where the conductive particle is dispersed into a solution containing the polymer electrolyte and the polymer electrolyte is adsorbed on at least part of the surface of the conductive particle, which is then rinsed, and a second step where the conductive particle which has adsorbed the polymer electrolyte is dispersed into a dispersion containing an inorganic oxide fine particle and the inorganic oxide fine particle is adsorbed on at least part of the surface of the conductive particle and the polymer electrolyte, which are then rinsed.

This process for producing a coated particle allows for efficient production of the coated particle used for the anisotropically conductive adhesive composition according to the present invention.

### Effect of the Invention

The present invention can provide an anisotropically conductive adhesive composition which can sufficiently prevent the occurrence of a short circuit between neighboring circuit electrodes by aggregation of a dispersed conductive particle, thus providing excellent long-term connection reliability even for fine-pitch connection, an anisotropically conductive film and a circuit member-connecting structure that both use the composition, and a process for producing a coated particle.

### Brief Description of the Drawings

Figure 1 is an outside view schematically illustrating an example of the coated particle according to the present invention;
Figure 2 is a process drawing showing an embodiment of the process for producing the coated particle according to the present invention;
Figure 3 is a schematic cross-sectional view of a preferred embodiment of the anisotropically conductive film according to the present invention; and
Figure 4 is a schematic cross-sectional view of a preferred embodiment of the circuit member-connecting structure according to the present invention.

### Description of Symbols

1, coated particle; 2, adhesive; 6, conductive particle; 7, polymer electrolyte; 8, inorganic oxide fine particle; 9, insulating material; 10, first circuit member; 11, first substrate; 12, first circuit electrode; 20, second circuit member; 21, second substrate; 22, second circuit electrode; 100, anisotropically conductive film; 100a, circuit-connecting member; and 200, circuit member-connecting structure.

### Best Modes for Carrying Out the Invention

The preferred embodiment of the present invention will be described in detail below by referring to the drawings as needed. In the drawings, the same reference characters are used for the same or equivalent parts and no repeated description is given.

The anisotropically conductive adhesive composition according to the present invention is an anisotropically conductive adhesive composition to connect a first circuit member where a first circuit electrode is formed on the principal surface of a first substrate and a second circuit member where a second circuit electrode is formed on the principal surface of a second substrate with the first circuit electrode and the second circuit electrode placed opposite, wherein the anisotropically conductive adhesive composition comprises an adhesive and a coated particle prepared by coating at least part of the surface of a conductive particle with an insulating material containing a polymer electrolyte and an inorganic oxide fine particle.

Examples of the adhesive as a constituent of the anisotropically conductive adhesive composition according to the present invention include a mixture of a thermoreactive resin and a curing agent. Preferable adhesives include a mixture of an epoxy resin and a latent curing agent. Examples of the latent curing agent include imidazole, hydrazide, boron trifluoride-amine complex, sulfonium salt, amine imide, polyamine salt, and dicyandiamide. Other adhesives used include a mixture of a radical reactive resin and an organic peroxide and a light-cured resin hardened by exposure to energy radiation such as ultraviolet light.

As the epoxy resin, bisphenol epoxy resins induced from epichlorohydrin and bisphenol A, F, AD, or the like, epoxy novalac resins induced from epichlorohydrin and phenol novolac or cresol novolac, naphthalene-based epoxy resins having a skeleton containing a naphthalene ring, and glycidylamine, glycidylether, and various other epoxy compounds having two or more glycidyl groups per molecule of biphenyl, a cycloaliphatic compound, etc., and the like can be used alone or in combination with two or more. High-purity products of these epoxy resins where the concentrations of impurity ions (e.g., Na⁺, Cl⁻), hydrolyzable chlorine, and the like are reduced to 300 ppm or less are preferably used in view of electromigration prevention.

Butadiene rubber, acrylic rubber, styrene-butadiene-styrene rubber, nitrile-butadiene rubber, silicone rubber, or the like can be mixed into the anisotropically conductive adhesive composition to reduce stress after adhesion or improve adhesion. In addition, the anisotropically conductive adhesive composition is used in the form of paste or film. Addition of a thermoplastic resin such as phenoxy resin, polyester resin, or polyamide resin as a film-forming polymer is effective in forming the anisotropically conductive adhesive composition into a film. These film-forming polymers are effective in stress relaxation when a reactive resin cures. Especially, a film-forming polymer having a functional group such as a hydroxy group is more preferably because of improved adhesion. Film formation is performed by dissolving or dispersing an adhesive composition comprising at least an epoxy resin, an acrylic rubber, and a latent curing agent in an organic solvent to form a liquid, applying the liquid onto a release substrate, and removing the solvent at or below the activation temperature of the curing agent. The solvent used at this time is preferably a solvent mixture of an aromatic hydrocarbon solvent and an oxygenated solvent to improve the solubility of the solvent.

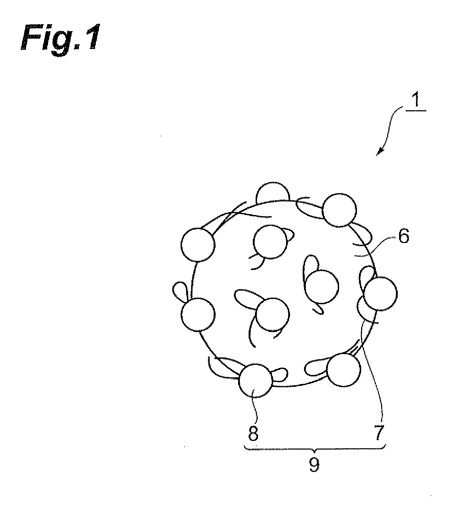

The coated particle as a constituent of the anisotropically conductive adhesive composition according to the present invention is a particle where at least part of the surface of a conductive particle is coated with an insulating material containing a polymer electrolyte and an inorganic oxide fine particle. Here, Figure 1 is an outside view schematically illustrating an example of the coated particle according to the invention. As shown in Figure 1, a coated particle 1 has a structure
where at least part of the surface of a conductive particle 6 is coated with an insulating material 9 containing a polymer electrolyte 7 and an inorganic oxide fine particle 8. In the invention, the state in which at least part of the surface of a conductive particle 6 is coated refers to the state in which particles having a smaller particle size are sprinkled on a particle having a larger particle size, as shown in Figure 1, when the coated particle is observed under a microscope.

In the present invention, examples of the conductive particle 6 as a constituent of the coated particle 1 include a particle containing a metal such as Au, Ag, Ni, Cu, solder, and the conductive particle is more preferably a particle prepared by forming a conductive layer of Au, Ag, Ni, Cu, solder, or the like on the surface of a spherical core material made of a polymer such as polystyrene. In addition, the conductive particle 6 may be a particle prepared by forming a surface layer of Su, Au, solder, or the like on the surface of a conductive particle.

The particle size of the conductive particle 6 needs to be smaller than the minimum space between electrodes of circuit members connected with the anisotropically conductive adhesive composition and if there is variation in the height of the electrodes, the particle size is preferably larger than the height variation. The mean particle size of the conductive particle 6 is preferably 1 to 10 µm (both inclusive), more preferably 2 to 4 µm (both inclusive). If the mean particle size is less than 1 µm, particle classification tends to be difficult while the mean particle size is greater than 10 µm, a short circuit tends to easily occur for fine-pitch connection between electrodes.

The coated particle 1 according to the present invention is a particle prepared by coating the surface of the conductive particle 6 with an insulating film comprising the insulating material 9 containing the polymer electrolyte 7 and the inorganic oxide fine particle 8. Here, the insulating material 9 is preferably a material prepared by alternately laminating the polymer electrolyte 7 and the inorganic oxide fine particle 8.

As a specific process for producing the coated particle 1, preferably used is a process including an adsorption step which alternately repeats (1) a first step where the conductive particle 6 is dispersed into a polymer electrolyte solution containing the polymer electrolyte 7 and the polymer electrolyte 7 is adsorbed on at least part of the surface of the conductive particle 6, which is then rinsed and (2) a second step where the conductive particle 6 which has adsorbed the polymer electrolyte 7 is dispersed into a dispersion containing the inorganic oxide fine particle 8 and the inorganic oxide fine particle 8 is adsorbed on at least part of the surfaces of the conductive particle 6 and the polymer electrolyte 7, which are then rinsed.

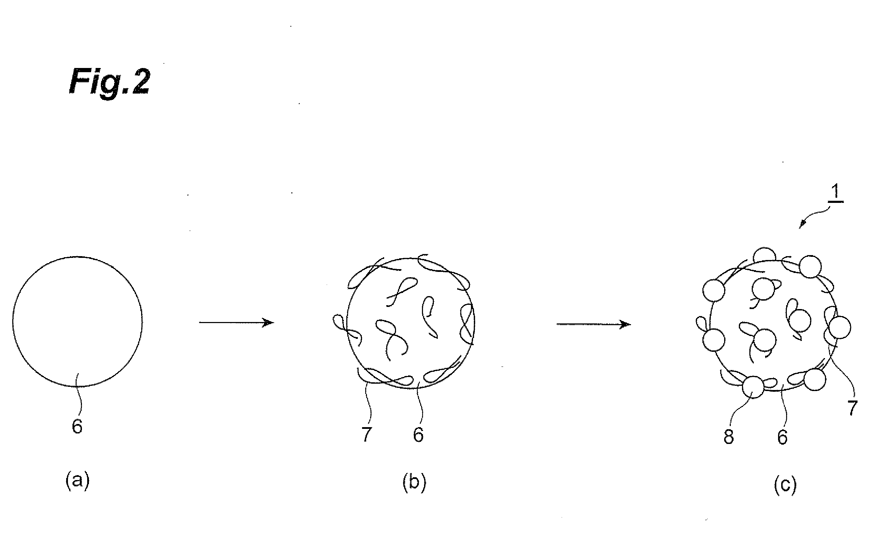

In the adsorption step, the first and second steps may be performed at least once each and may be performed twice or more times alternately. When the first and second steps are repeated twice or more times, the polymer electrolyte 7 and the inorganic oxide fine particle 8 are adsorbed on the conductive particle 6 in the first and second steps performed first, on which the polymer electrolyte 7 and the inorganic oxide fine particle 8 are then adsorbed again in the first and second steps performed second. The inclusion of the adsorption step repeating the first and second steps alternately allows for efficient production of the coated particle 1 coated with the insulating material 9 where the polymer electrolyte 7 and the inorganic oxide fine particle 8 are alternately laminated on the surface of the conductive particle 6. Here, Figure 2 is a process drawing showing an embodiment of the process for producing the coated particle 1 according to the present invention. As shown in Figures 2(a) to (c), the coated particle 1 can be obtained by adsorbing the polymer electrolyte 7 on at least part of the surface of the conductive particle 6 in the first step and then adsorbing the inorganic oxide fine particle 8 on at least part of the surfaces of the conductive particle 6 and the polymer electrolyte 7 in the second step.

This method is called layer-by-layer assembly. The layer-by-layer assembly is the process for forming an organic thin film presented by G. Decher et al in 1992 (Thin Solid Films, 210/211, p. 831(1992)). In this process, a substrate is alternately immersed in an aqueous solution of a positively charged polymer electrolyte (polycation) and an aqueous solution of a negatively charged polymer electrolyte (polyanion) and thereby a pair of the polycation and polyanion adsorbed by electrostatic attraction is laminated on the substrate to obtain a composite film (layer-by-layer assembled film).

In layer-by-layer assembly, electrostatic attraction allows the charge of a material formed on a substrate and an oppositely charged material in the solution to attract each other, causing film growth, so when the adsorption proceeds until charge neutralization occurs, no further adsorption occurs. Therefore, when a saturation point is reached, the film thickness does not increase any more. Lvov et al applied layer-by-layer assembly to fine particles and reported a process for using dispersions of silica, titania, and ceria fine particles to laminate the fine particles and a polymer electrolyte charged oppositely to the surface charge of the fine particles by layer-by-layer assembly (Langmuir, Vol. 13, (1997) pp. 6195-6203). This process allows for the formation of a fine particle-laminated thin film where a silica fine particle and a polymer electrolyte are alternately laminated by alternately laminating a silica fine particle having a negative surface charge and polydiallyldimethylammonium chloride (PDDA), polyethylenimine (PEI), or the like that is a polycation having a charge opposite to the negative charge.

After the conductive particle 6 is immersed in a polymer electrolyte solution or an inorganic oxide fine particle dispersion, excess polymer electrolyte solution or inorganic oxide fine particle dispersion is preferably rinsed off by rinsing with a solvent alone before the particle is immersed in an oppositely charged fine particle dispersion or polymer electrolyte solution. Such solvents used for rinsing include water, alcohol, and acetone, but ion exchanged water having a specific resistance value of 18 MΩ·cm or more (so-called ultrapure water) is usually used in view of removal of excess polymer electrolyte solution or inorganic oxide fine particle dispersion. The polymer electrolyte 7 and the inorganic oxide fine particle 8 adsorbed on the conductive particle 6 adsorb each other and are electrostatically adsorbed on the surface of the conductive particle 6, so they are not separated from the surface in the rinsing step. Furthermore, because of the polarization of the polar groups (mainly a hydroxy group) on the surface of the inorganic oxide fine particle 8, electrostatic interaction (attraction) with metal or partial metal oxide, for example, on the surface of the conductive particle 6 is active. In addition, the conductive particle is preferably rinsed to prevent the carrying of the unabsorbed polymer electrolyte 7 or inorganic oxide fine particle 8 into the oppositely charged solution. If this rinsing is not performed, the carrying allows the cation and anion to mix in the solution and may cause aggregation with the polymer electrolyte 7 and the inorganic oxide fine particle 8 or precipitation.

As the polymer electrolyte 7, a polymer (polyanion or polycation) having a charged functional group in the main chain or a side chain which ionizes in an aqueous solution can be used. In this case, the polyanion is generally a compound having a functional group which can be negatively charged such as sulfonic acid, sulfuric acid, and carboxylic acid, and examples of the polyanion used include polystyrene sulfonate (PSS), polyvinyl sulfate (PVS), dextran sulfate, chondroitin sulfate, polyacrylic acid (PAA), polymethacrylic acid (PMA), polymaleic acid, and polyfumaric acid. In addition, the polycation is generally a compound having a functional group such as a quaternary ammonium group or an amino group which can be positively charged, and examples of the polycation used include polyethylenimine (PEI), polyallylamine hydrochloride (PAH), polydiallyldimethylammonium chloride (PDDA), polyvinylpyridine (PVP), polylysine, polyacrylamide, and a copolymer containing at least one thereof.

Of these polymer electrolytes 7, polymer electrolytes which contain no alkali metal (Li, Na, K, Rb, and Cs) ion, alkaline earth metal (Ca, Sr, Ba, and Ra) ion, or, halide ion (fluorine ion, chloride ion, bromine ion, and iodine ion) are preferable to avoid the occurrence of electromigration or corrosion.

These polymer electrolytes 7 are all water-soluble or soluble in a mixture of water and an organic solvent. The molecular weight of the polymer electrolyte 7 varies depending on the type of the polymer electrolyte 7 used and cannot be determined unconditionally but generally is preferably about 300 to 200,000. Generally the concentration of the polymer electrolyte 7 in a solution is preferably about 0.01 to 10 mass %. In addition, the pH of the polymer electrolyte solution is not particularly limited.

The polymer electrolyte solution used in the present invention is generally a solution prepared by dissolving the polymer electrolyte 7 in water or a solvent mixture of water and a water-soluble organic solvent. Examples of the water-soluble organic solvent which can be used include methanol, ethanol, propanol, acetone, dimethylformamide, and acetonitrile.

With these polymer electrolytes 7, polymer electrolyte thin film can be uniformly formed on the surface of the conductive particle 6 without defects. Even if the space between circuit electrodes is fine pitched, sufficient insulation can be ensured and good electric connection can be obtained between electrodes placed opposite to be electrically connected because of low connection resistance between the electrodes.

The inorganic oxide fine particle 8 preferably comprises an oxide containing at least one element selected from the group consisting of silicon, aluminum, zirconium, titanium, niobium, zinc, tin, cerium, and magnesium, and these oxides can be used alone or in combination with two or more. Furthermore, because of its excellent insulation, particle size-controlled water-dispersible colloidal silica (SiO₂) is the most preferable. Examples of a commercially available product of this inorganic oxide fine particle 8 include SNOWTEX and SNOWTEX UP (Nissan Chemical Industries, Ltd.) and Quartron PL series (Fuso Chemical Co., Ltd.). In view of sufficient insulation reliability, the total concentration of the alkali metal ions and alkaline earth metal ions in a dispersion is preferably 100 ppm or less. In addition, an inorganic oxide fine particle produced by the hydrolysis reaction of a metal alkoxide, the so-called sol-gel process, is preferably used.

The mean particle size of the inorganic oxide fine particle 8 determined by BET specific surface area analysis or X-ray small angle scattering is preferably 20 nm to 500 nm (both inclusive). If the mean particle size of the inorganic oxide fine particle 8 is less than 20 nm, the inorganic oxide fine particle 8 adsorbed on the conductive particle 6 does not function sufficiently as an insulating film and tends to easily cause a short circuit partially. On the other hand, if the mean particle size is greater than 500 nm, the conductivity in the direction of pressurization during connection tends to be insufficient.

In addition, the content of the coated particle 1 in the anisotropically conductive adhesive composition is preferably 0.1 to 30 vol % (both inclusive), more preferably 0.2 to 15 vol % (both inclusive) with respect to the total volume of the solid content in the anisotropically conductive adhesive composition. If this content is less than 0.1 vol %, conductivity tends to decrease while the content is greater than 30 vol %, insulation tends to decrease.

Aside from the coated particle 1, an inorganic filler can be mixed and disperse into the anisotropically conductive adhesive composition according to the present invention. The inorganic filler is not particularly limited, and examples thereof include powders of molten silica, crystalline silica, calcium silicate, alumina, calcium carbonate, and the like. The content of the inorganic filler is preferably 10 to 200 mass parts (both inclusive) with respect to 100 mass parts of the adhesive. A higher content of the inorganic filler is more effective in reducing the coefficient of thermal expansion of the anisotropically conductive adhesive composition. However, a too high content tends to easily cause poor continuity because of reduced adhesion or exclusion of the adhesive at the connection while a too low content cannot reduce the coefficient of thermal expansion sufficiently. Therefore, the content of the inorganic filler is more preferably 20 to 90 mass parts (both inclusive) with respect to 100 mass parts of the adhesive. In addition, the mean particle size of the inorganic filler is preferably 3 µm or less in view of the prevention of poor continuity at the connection. In addition, a spherical filler is preferably used in view of the prevention of reduced fluidity of the resin and damage to the chip passivation film during connection. The inorganic filler can also be used with the coated particle 1 and can also be mixed and dispersed into a layer without the coated particle 1 if an anisotropically conductive film is formed by using the anisotropically conductive adhesive composition and the adhesive layer is made multilayered.

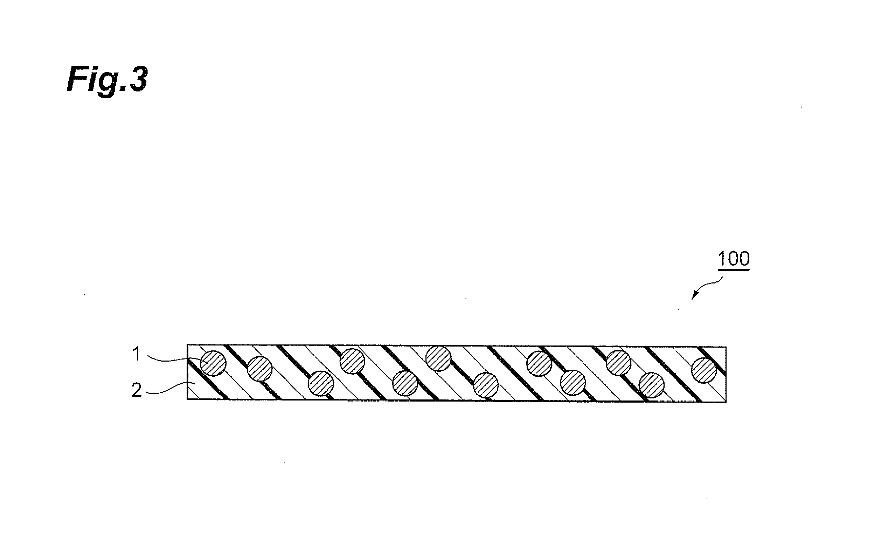

Figure 3 is a schematic cross-sectional view illustrating a preferred embodiment of the anisotropically conductive film (circuit-connecting adhesive film) according to the present invention. The anisotropically conductive film 100 shown in Figure 3 is a film into which an anisotropically conductive adhesive composition containing the coated particle 1 and an adhesive 2 is formed.

The anisotropically conductive film 100 can be obtained, for example, by applying a liquid anisotropically conductive adhesive composition on a release film with a roll coater or the like, drying the applied composition, and then separating the dried composition from the release film. As the release film, a PET film or the like surface-treated to make the film have release properties can be preferably used.

In addition, the adhesive layer of the anisotropically conductive film 100 can also be made multilayered. For example, the film can be an anisotropically conductive film having a two-layer structure prepared by laminating an adhesive layer containing a coated particle to make the film anisotropically conductive and an adhesive layer containing no coated particle or conductive particle or an anisotropically conductive film having a three-layer structure prepared by laminating an adhesive layer containing no coated particle or conductive particle on both sides of an adhesive layer containing a coated particle. These anisotropically conductive films having a multilayer structure can trap a conductive particle efficiently on connection electrodes, so they are advantageous for fine-pitch connection. In addition, in view of adhesion to circuit members, the circuit members can also be connected together after an adhesive film having excellent adhesion is laminated on each of the circuit members placed opposite.

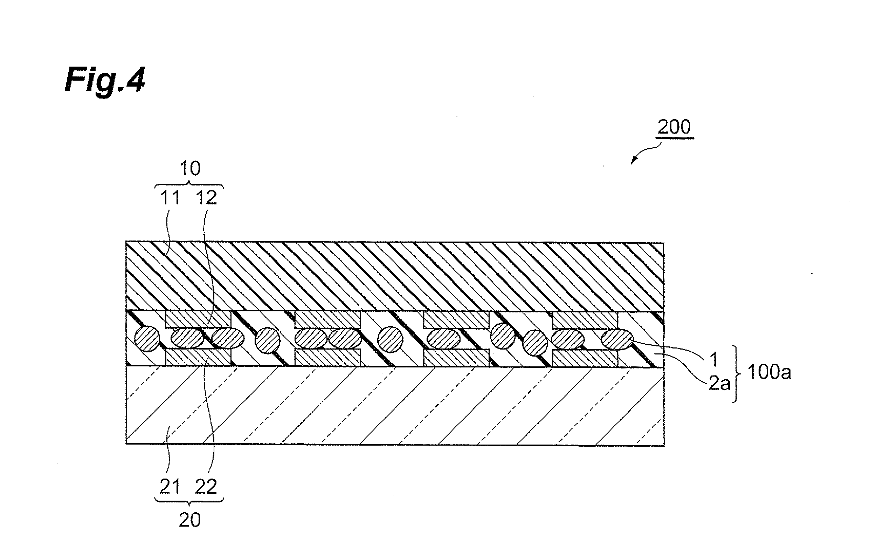

Figure 4 is a schematic cross-sectional view illustrating a preferred embodiment of a circuit member-connecting structure according to the present invention. In the circuit member-connecting structure 200 shown in Figure 4, a first circuit member 10 having a first substrate 11 and a first circuit electrode 12 formed on the principal surface thereof and a second circuit member 20 having a second substrate 21 and a second circuit electrode 22 formed on the principal surface thereof are connected by a circuit-connecting member 100a formed between the first and second circuit members 10 and 20 which comprises a cured product of the anisotropically conductive adhesive composition or the anisotropically conductive film 100 according to the present invention. In the circuit member-connecting structure 200, the first circuit electrode 12 and the second circuit electrode 22 are placed opposite and electrically connected.

The circuit-connecting member 100a comprises a cured product of the anisotropically conductive adhesive composition or the anisotropically conductive film 100 according to the present invention and contains a cured product 2a of the adhesive 2 and the coated particle 1 dispersed therein. The first circuit electrode 12 and the second circuit electrode 22 are electrically connected via the coated particle 1.

The first and second circuit members 10 and 20 are not particularly limited if they have electrodes requiring electric connection formed. Examples of the circuit members include a glass or plastic substrate having electrodes formed from ITO or the like used for liquid crystal displays, a printed wiring board, a ceramic wiring board, a flexible wiring board, and a semiconductor silicon chip, and these are used in combination as needed. In this way, in the present embodiment, printed wiring boards and other circuit members having a variety of different surface conditions made of organic substances such as polyimide, metals such as copper and aluminum, and inorganic materials such as indium tin oxide (ITO), silicon nitride (SiN_{X}), and silicon dioxide (SiO₂) can be used.

The circuit member-connecting structure 200 is obtained, for example, by a method which connects the first circuit member 10 and the second circuit member 20 so that the first circuit electrode 11 and the second circuit electrode 21 are electrically connected by laminating the first circuit member 10, the anisotropically conductive film 100 according to the present invention, and the second circuit member 20 in this order in a way that places the first circuit electrode 11 and the second circuit electrode 21 opposite and heating and pressurizing the laminate.

In this method, first, the anisotropically conductive film 100 formed on a release substrate is heated and pressurized with the film bonded onto the second circuit member 20 to allow the anisotropically conductive film 100 to tentatively adhere to the circuit member. After the release substrate (mold-release film) is separated, the first circuit member 10 is put on the film while the circuit electrodes are aligned with each other. In this way, a laminate where the second circuit member 20, the anisotropically conductive film 100, and the first circuit member 10 are laminated in this order can be prepared.

The conditions for heating and pressurizing the laminate are appropriately adjusted depending on the curing properties of the adhesive 2 in the anisotropically conductive film 100 and the like so that sufficient adhesive strength is obtained when the anisotropically conductive film cures.

### Examples

The present invention will be described more specifically below by using Examples, but the invention is not limited to these Examples.

### [Example 1]

### Preparation of a coated particle

A metal film-coated conductive resin particle was obtained as a conductive particle by forming a 90 nm-thick nickel film on the surface of a resin particle (polystyrene spherical resin particle having a mean particle size of 3 µm, Merck Chime SAS, trade name Estapor L300) by electroless nickel plating and further forming a 30 nm-thick gold film on the nickel film by immersion gold plating.

Next, the surface of the conductive particle obtained was coated with an insulating material in the following way. Polyethylenimine which is a cationic polymer was used as the polymer electrolyte and silica was used as the inorganic oxide fine particle. First, an aqueous solution of polyethylenimine (concentration of 30 mass %, Nippon Shokubai Co., Ltd., trade name, EPOMIN P1000) was diluted with ultrapure water (18 MΩ·cm) and adjusted to a concentration of 0.3 mass %. In addition, a dispersion of colloidal silica (concentration of 20 mass %, Fuso Chemical Co., Ltd., trade name Quartron PL-13, mean particle size of 130 nm) was also diluted with ultrapure water (18 MΩ·cm) and adjusted to a concentration of 0.1 mass %. The silica fine particles in this dispersion of colloidal silica had a surface potential (zeta potential) of -20 mV.

2 g of the conductive particle was added to 200 g of the aqueous solution of polyethylenimine (concentration of 0.3 mass %), which was then stirred for 15 minutes to prepare a polymer electrolyte-coated particle where polyethylenimine was adsorbed on the surface of the conductive particle. Then, the polymer electrolyte-coated particle was filtered off with a membrane filter having a pore size of 1 µm (Millipore) and the particle deposited was rinsed twice on the membrane filter with 200 g of ultrapure water to remove unadsorbed polyethylenimine. Next, the polymer electrolyte-coated particle recovered from the membrane filter was added to 200 g of the dispersion of colloidal silica (concentration of 0.1 mass %), which was then stirred for 15 minutes to prepare a coated particle where silica fine particles were on the surface of the polymer electrolyte-coated particle. Then, the coated particle was filtered off with a membrane filter having a pore size of 1 µm in the same way as above and the particle deposited was rinsed twice on the membrane filter with 200 g of ultrapure water to remove unadsorbed colloidal silica fine particles. Furthermore, the coated particle was rinsed with 200 g of isopropyl alcohol to remove water. Then, the coated particle recovered from the membrane filter was stored in an oven at 80°C for 1 hour to evaporate the isopropyl alcohol. As a result, a coated particle coated with an insulating material comprising polyethylenimine and colloidal silica having a mean particle size of 130 nm alternately adsorbed on the surface of a conductive particle was obtained.

### Preparation of an anisotropically conductive adhesive composition

An adhesive solution was prepared by following the procedure below. First, 100 g of a phenoxy resin (Union Carbide Corporation, trade name PKHC) and 75 g of an acrylic rubber (a copolymer of 40 mass parts of butyl acrylate, 30 mass parts of ethyl acrylate, 30 mass parts of acrylonitrile, and 3 mass parts of glycidyl methacrylate; weight-average molecular weight, 0.85 million) were dissolved in 400 g of ethyl acetate to obtain a resin solution having a solid content of 30 mass %. Next, 300 g of a liquid epoxy resin containing a microencapsulated latent curing agent (epoxy equivalent of 185, Asahi Kasei Epoxy Co., Ltd., trade name Novacure HX-3941) was added to the resin solution, which was then stirred to prepare the adhesive solution.

Next, the coated particle was dispersed in the adhesive solution so that the coated particle was 9 volume parts with respect to 100 volume parts of the solid content in the adhesive solution, to obtain an aqueous solution of an anisotropically conductive adhesive composition.

### Preparation of an anisotropically conductive film

The solution obtained was applied onto a separator (siliconized polyethylene terephthalate film, 40 µm thick) by using a roll coater and then the applied solution was dried at 90°C for 10 minutes to form a 25 µm-thick anisotropically conductive adhesive layer. An anisotropically conductive film was obtained from this.

### Preparation of a circuit member-connecting structure

A chip (1.7 × 1.7 mm, 0.5 µm thick) having gold bumps (area, 30 × 90 µm; space, 10 µm; height, 15 µm; and number of bumps, 362) and a glass substrate (0.7 mm thick) having an Al circuit were connected by following the procedure below. First, the anisotropically conductive film (2 × 19 mm) was bonded to the glass substrate having an Al circuit by heating and pressurizing them under the conditions of 80°C and 0.98 MPa (10 kgf/cm²) and then the separator was separated from the anisotropically conductive film before the chip gold bumps and the Al circuit were aligned with each other.

Next, the connection was accomplished by heating and pressurization from the top of the chip under the conditions of 190°C, 40 g/bump, and 10 seconds. In this way, a circuit member-connecting structure was prepared. In the circuit member-connecting structure obtained, the connection resistance was up to 100 mΩ per bump and averaged 30 mΩ while the insulation resistances between neighboring bumps were all 1 × 10⁸ Ω or more. In addition, it was found that the structure exhibited good long-term connection reliability because these values remained unchanged even after 1000 cycles of a thermal shock test where the structure was maintained at -40°C for 30 minutes, heated to 100°C, and maintained at 100°C for 30 minutes.

### [Comparative Example 1]

Another anisotropically conductive film was prepared in the same way as in Example 1 except that the same metal film-coated conductive resin particle as in Example 1 whose surface was not coated with an insulating material was used instead of the coated particle as a conductive particle.

Next, with the anisotropically conductive film prepared, a chip (1.7 × 1.7 mm, 0.5 µm thick) having gold bumps (area, 40 × 90 µm; space, 10 µm; height, 15 µm; and number of bumps, 362) and a glass substrate having an Al circuit (0.7 mm thick) were connected by following the procedure below.

First, the anisotropically conductive film (2 × 19 mm) was bonded to the glass substrate having an Al circuit by heating and pressurizing them under the conditions of 80°C and 0.98 MPa (10 kgf/cm²) and then the separator was separated from the anisotropically conductive film before the chip gold bumps and the Al circuit were aligned with each other.

Next, the connection was accomplished by heating and pressurization from the top of the chip under the conditions of 190°C and 40 g/bump, and 10 seconds. In this way, a circuit member-connecting structure was prepared. In the circuit member-connecting structure obtained, the connection resistance was up to 130 mΩ per bump and averaged 80 mΩ while the insulation between neighboring bumps was not ensured sufficiently, causing a short circuit between some bumps which was associated with the aggregation of the conductive particle.

The anisotropically conductive adhesive composition according to the present invention can prevent the occurrence of a short circuit between conductive particles because of an insulating film containing a polymer electrolyte and inorganic oxide fine particles and improve the fine pitch connectivity even if the coated particle aggregates in a space between neighboring electrodes which is 15 µm or less because of the use of the coated particle where the surface of a conductive particle is uniformly coated with a polymer electrolyte thin film and inorganic oxide fine particles. In addition, the anisotropically conductive adhesive composition has great ease of handling for use in an adhesive in film form.

Therefore, the anisotropically conductive adhesive composition according to the present invention can be preferably used to electrically connect (1) an LCD, a plasma display, or an organic EL panel and a TAB or an FPC, (2) a TAB and an FPC, (3) an LCD, a plasma display, or an organic EL panel and an IC chip, (4) an IC chip and a printed circuit board, and the like only in the direction of pressurization during connection, and has excellent connection reliability.

### Industrial Applicability

As described above, the present invention can provide an anisotropically conductive adhesive composition which can prevent the occurrence of a short circuit between neighboring circuit electrodes sufficiently because of aggregation of a dispersed conductive particle even for fine pitch connection and can thus provide excellent long-term connection reliability, an anisotropically conductive film and a circuit member-connecting structure which both use the composition, and a process for producing a coated particle.

## Claims

1. An anisotropically conductive adhesive composition to connect a first circuit member where a first circuit electrode is formed on the principal surface of a first substrate and a second circuit member where a second circuit electrode is formed on the principal surface of a second substrate with the first circuit electrode and the second circuit electrode placed opposite,
wherein the anisotropically conductive adhesive composition comprises an adhesive and a coated particle where at least part of the surface of a conductive particle is coated with an insulating material containing a polymer electrolyte and an inorganic oxide fine particle.

2. The anisotropically conductive adhesive composition according to claim 1 wherein the coated particle is prepared by electrostatically adsorbing the polymer electrolyte and the inorganic oxide fine particle alternately on at least part of the surface of the conductive particle.

3. The anisotropically conductive adhesive composition according to claim 1 or 2 wherein the inorganic oxide fine particle comprises an oxide containing at least one element selected from the group consisting of silicon, aluminum, zirconium, titanium, niobium, zinc, tin, cerium, and magnesium.

4. The anisotropically conductive adhesive composition according to any one of claims 1 to 3 wherein the mean particle size of the inorganic oxide fine particle is in the range of 20 to 500 nm (both inclusive).

5. The anisotropically conductive adhesive composition according to any one of claims 1 to 4 wherein the polymer electrolyte contains no alkali metal ion, alkaline earth metal ion, or halide ion.

6. An anisotropically conductive film that is a film into which the anisotropically conductive adhesive composition according to any one of claims 1 to 5 is formed.

7. A circuit member-connecting structure wherein
a first circuit member where a first circuit electrode is formed on the principal surface of a first substrate and
a second circuit member where a second circuit electrode is formed on the principal surface of a second substrate
are connected by a circuit-connecting member comprising a cured product of the anisotropically conductive adhesive composition according to any one of claims 1 to 5 put between the first circuit member and the second circuit member so that the first circuit electrode and the second circuit electrode are placed opposite and electrically connected.

8. The circuit member-connecting structure according to claim 7 wherein
in the first circuit member, the first substrate is a glass substrate and the first circuit electrode is a metal electrode circuit and
in the second circuit member, the second substrate is an organic insulating substrate.

9. The circuit member-connecting structure according to claim 7 wherein
in the first circuit member, the first substrate is a semiconductor chip and
in the second circuit member, the second substrate is a glass substrate and the second circuit electrode is a metal electrode circuit.

10. A process for producing a coated particle where at least part of the surface of a conductive particle is coated with an insulating material,
wherein the process comprises an adsorption step which alternately repeats
a first step where the conductive particle is dispersed into a solution containing a polymer electrolyte and the polymer electrolyte is adsorbed on at least part of the surface of the conductive particle, which is then rinsed and
a second step where the conductive particle which has adsorbed the polymer electrolyte is dispersed into a dispersion containing an inorganic oxide fine particle and the inorganic oxide fine particle is adsorbed on at least part of the surfaces of the conductive particle and the polymer electrolyte, which are then rinsed.
